# EUROPEAN PATENT APPLICATION

(11) **EP 4 679 110 A1**
(43) Date of publication of application: **14.01.2026**
(21) Application number: 24306163.7
(22) Date of filing: 10.07.2024
(51) Int. Cl.: G01R 31/28

(54) **ELECTRONIC BOARD FAULT IDENTIFICATION METHOD, CORRESPONDING DEVICE, SYSTEM AND COMPUTER PROGRAM**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: DEGRENNE, Nicolas, 35708 RENNES CEDEX 7 (FR); FOUBE, Laurent, 35708 RENNES CEDEX 7 (FR); COUSINEAU, Denis, 35708 RENNES CÉDEX 7 (FR); MENTRE, David, 35708 RENNES CÉDEX 7 (FR)
(74) Representative: Plasseraud IP

(57) **Abstract**

The disclosure relates to a method for locating faulty components on an electronic board (EB), the method being implemented thru by an electronic board test device (ECTD) comprising a processor (Pu) and a memory (Mem), the method comprising:
- obtaining (S01) a digital testing package (DTP), from a communication interface (COM) of the electronic board test device (ECTD),
- from the digital testing package (DTP), the processor (Pu) obtaining (S02) at least one test vector database (TVD),
- connecting (S03) the electronic board test device (ECTD) to the electronic board (EB) using at least one connector of the electronic board test device (ECTD) according to a connection scheme (CoS),
- setting (S04) a power supply unit of the electronic board test device (ECTD) to provide predetermined voltage and/or current levels to the connected electronic board (EB),
- executing (S05) at least one test according to the test vectors of the at least one test vector database (TVD) and determining the faulty components as a function of at least one measured sensor signature of the at least one test.

## Description

### Domain

The disclosure relates to the identification of faulty components or group of components on electrical circuitry. More specifically, the invention relates to the determination, on an electric circuit board, of the components which are likely to produce a malfunction of all or part of the circuit. The disclosure is particularly adapted to prolong the life of electronic board, more specifically to power electric circuits.

### Prior Art

While sustainability and ecodesign of product becomes a selection criterion in many situations, designing electric and electronic products that can achieve these objectives is increasingly hard.

Electronic products or systems (battery charging systems, motor drive inverters, HVAC, i.e. air conditioning systems, etc) are becoming increasingly complex, integrating one or more power electronic converters, themselves comprising numerous modules and components. These modules and components include, for example, electronic switches such as IGBTs ("*Insulated Gate Bipolar Transistors*") or other power devices (MOSFET, i.e. "*Metal Oxide Semiconductor Field Effect Transistor*", thyristors, diodes, etc), and passive components such as resistors, capacitors, transformers and inductors. Similarly, power electronics converters (such as DC to AC converters, i.e., inverters, DC to DC converters, synchronous rectifiers, etc.) can also include several (sub-)circuit boards, such as gate driver boards, EMI filter and controller board (including a DSP, or other kind of microprocessor, FPGA, etc.). These circuit boards themselves also include numerous electronic components (capacitors, resistors, electronic switches, transistors, integrated circuits for example). To make these power converters and possibly also sub-circuit boards "maintainable", it is needed to identify which modules and/or components are faulty in the event of a fault. This identification must ultimately enable either the modules in question to be replaced, or the faulty components to be replaced (for example, by desoldering them and replacing them with new components).

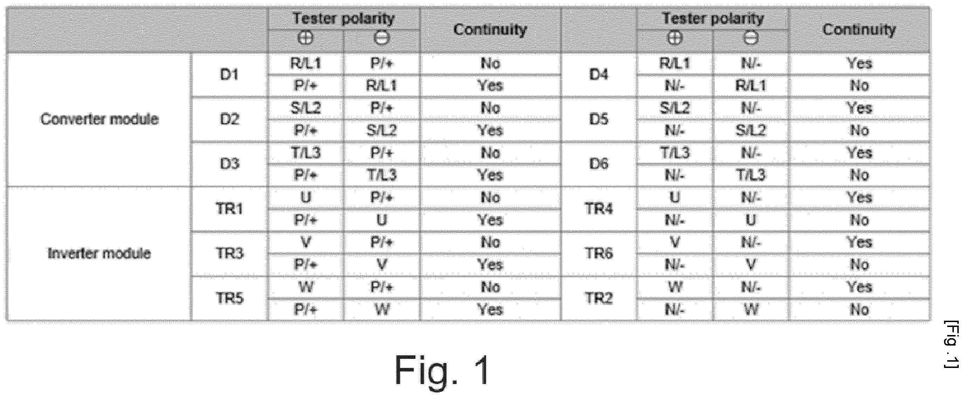

To date, the question of the maintainability of such electrical or electronic equipment is partly addressed by the provision, for some of this equipment, of a "data sheet" of tests to be carried out. For example, a paper or digital form details the series of manual tests to be carried out on the components of an electronic board (for example, a power electronics board) in order to determine which component or components may be faulty. Figure 1 shows, purely by way of illustration, such a data sheet for tests to be carried out on a simple inverter comprising only 6 diodes and 6 transistors.

This methodology has several disadvantages, including: a bad scalability (since the process is only manual), a bad completeness (since test result might be caused by another fault than the considered one). The process is also time-consuming and presents a high risk of error (because of the manual definition and interpretation of the tests results). For example, relying on the example of figure 1, after performing the 24 required tests, two results may be expected:
- all the test results are according to the specification: one can conclude that there is no failure in the tested device, but there may be a failure elsewhere,
- at least one test result is not according to spec: one can conclude that there is a failure in the tested device, but also that there may be a failure elsewhere.

Consequently, these tests are not sufficient to repair the inverter with high confidence since they only address selected failures of the main power semi-conductors. In addition, these tests are numerous (24 tests in the example) and each require a specific connection of the diagnostic device.

Overall: the scalability and completeness are low; the test duration is high; the tests are difficult to automatize; the risk of test error (performing or interpretation) is high. Therefore, despite the presence of this test sheet, the repairability of the power electronic system is finally low.

The disclosure improves the situation.

### Summary

Hence, the disclosure relates to a method for locating faulty components on an electronic board, the method being implemented thru by an electronic board test device comprising a processor and a memory, the method comprising:
- obtaining a digital testing package, from a communication interface of the electronic board test device,
- from the digital testing package, the processor obtaining at least one test vector database,
- connecting the electronic board test device to the electronic board using at least one connector of the electronic board test device according to a connection scheme,
- setting a power supply unit of the electronic board test device to provide predetermined voltage and/or current levels to the connected electronic board,
- executing at least one test according to the test vectors of the at least one test vector database and determining the faulty components as a function of at least one measured sensor signature of the at least one test.

According to a feature, the at least one test vector database comprises at least one test vector, each test vector comprising a plurality of input values to be applied to inputs of the electronic board, named input vector, and a plurality of sensor(s) values associated with the input vector, named sensor(s) signatures linked to the number of possible faults on the electronic board.

According to a feature, the digital testing package comprises, in addition to the test vector database, the connection scheme.

According to a feature, the processor obtaining the at least one test vector database from the digital testing package comprises the electronic board test device determining consistency of the digital testing package, wherein determining consistency comprises checking that the digital testing package comprises the at least one test vector database and one test protocol data structure.

According to a feature, obtaining the digital testing package comprises the electronic board test device determining a licence to use the digital testing package, determining a licence comprising optionally obtaining, from a digital testing package owner a digital authorization to use the digital testing package to test the electronic board and/or checking that a digital authorization exists within a memory of the electronic board test device.

Thus, security of operation is ensured since only the owner or manufacturer of the digital testing package can provide an authorization, to a given number of electronic board test device (it can be one) to use the (genuine) digital testing package for a given number of tests. This licence can be submitted to a payment of a using fee.

According to a feature, determining consistency of the digital testing package further comprises determining that an identifier of the at least one test vector database corresponds to an expected identifier regarding the electronic board.

According to a feature, determining consistency of the digital testing package further comprises determining that an identifier of the electronic board corresponds to a prerecorded identifier of the electronic board in the digital testing package.

According to a feature, the processor obtaining the at least one test vector database from the digital testing package comprises the electronic board test device deciphering the digital testing package and storing the uncyphered digital testing package in a dedicated memory location of the electronic board test device.

According to a feature, the electronic board test device deciphering the digital testing package comprises the electronic board test device obtaining cryptographic materials dedicated to the digital testing package.

According to a feature, executing at least one test according to the test vectors of the at least one test vector database comprises:
- at least one iteration of a testing stage steps comprising:
   - applying a test vector of said at least one test vector database,
   - acquiring values from the sensors associated to the electronic board,
   - storing the acquired values along with the test vector in a diagnosis data structure,
- comparing at least one of said acquired values of the diagnosis data structure with the records of corresponding signatures of the at least one test vector database, and in the event of a match of at least one of the acquired values, delivering the corresponding fault location.

According to a feature, after executing the at least one test, transmitting at least one result of the at least one test to a manufacturer of the electronic board.

According to another aspect, the disclosure also relates to an electronic board test device for locating faulty components on an electronic board, the electronic board test device comprising a processor and a memory. The electronic board test device further comprising:
- a communication interface for obtaining a digital testing package,
- means for the processor obtaining at least one test vector database from the digital testing package,
- means for connecting the electronic board test device to the electronic board using at least one connector of the electronic board test device according to a connection scheme,
- means for setting a power supply unit of the electronic board test device to provide predetermined voltage and/or current levels to the connected electronic board, and
- means for executing at least one test according to the test vectors of the at least one test vector database and determining the faulty components as a function of at least one measured sensor signature of the at least one test.

In another aspect, the disclosure also relates to a computer program comprising instructions causing the implementation of the method as disclosed.

In another aspect, the disclosure also relates to a data storage medium comprising digital testing package comprising at least one at least one test vector database to be obtained by an electronic board test device as disclosed above.

### Drawings

More details are presented in the specification below, with reference to the appended drawings where:
- Figure 1, already presented, shows a simple example of a fault detection data sheet, with module device numbers and terminal to be checked,
- Figure 2 illustrates a simplified architecture of an electronic board test device according to the disclosure,
- Figure 3 illustrates a simplified method for implementing a test vector database on an electronic board according to the disclosure,
- Figure 4 illustrates the steps of a test execution method according to the disclosure,
- Figure 5 illustrates a simple example a flattened version of a test vector database according to the disclosure.

### Description of embodiments

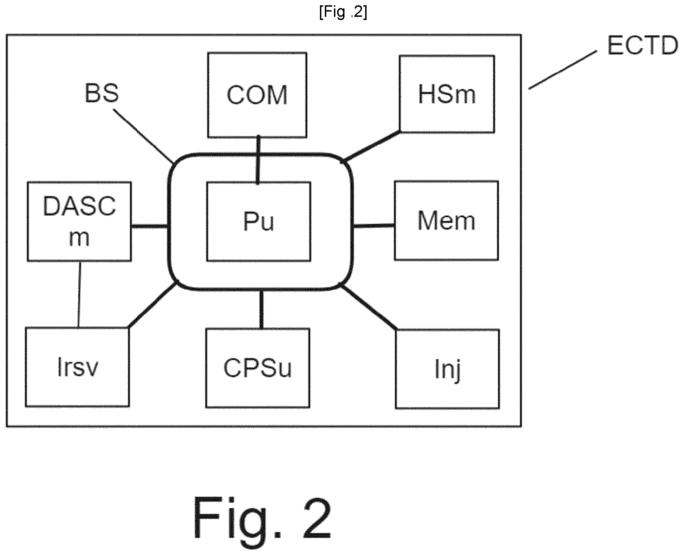

As previously explained, the disclosure is about an electronic board test device (also called ECTD) and its operations thereof. The electronic board test device is illustrated in figure 2. The electronic board test device comprises the necessarily output interface to connect some test sensors to particular signals within the power converter, to connect to control inputs of electronic board and to provide a specific test power supply. The ECTD is thus a specialized computer-based system designed to perform comprehensive testing and fault diagnosis on electronic boards. It combines, in some implementations, digital and analog interfaces, allowing it to inject precise voltage and current signals at predetermined locations within the electronic board under test, while simultaneously retrieving and analysing sensor data. The ECTD is equipped with a processing unit Pu and a memory Mem, typically a microcontroller or an embedded computer, responsible for executing test routines (according to test vectors), processing acquired data, and performing fault analysis algorithms. The ECTD comprises an electronically configurable power supply unit CPSu providing the required voltage and current levels to power the electronic board under test. This unit can simulate different power conditions, according to the values of the test vectors, allowing for testing under various load scenarios. According to the disclosure, a test vector comprises a plurality of input values to be applied to inputs of the electronic board, named input vector, and a plurality of sensor(s) values associated with the input vector, named sensor(s) signatures linked to the number of possible faults on the electronic board.

In any case, the ECTD comprises, injectors Inj (which enable the test vectors of the electronic board to be reproduced). These injectors are part or all individually parameterizable (in particular as a function of the values of the test vectors), in terms of voltage and current intensity to be supplied, for each input of the electronic board. The injectors can also be parameterizable as a function of an electrical waveform to be applied to the electric signal for example, a sinusoidal waveform is a regular and periodic waveform that oscillates between positive and negative values, etc., depending of the optional requirements of the tests vectors.

The ECTD also includes at least one interface for retrieving sensor values IRSv, enabling the voltage produced during the test series to be read. This interface may comprise cables enabling the voltage values obtained by the sensors to be read (when these sensors are already present on the electronic board) and/or sensors fitted with cables, the sensors then being carried in the ECTD.

Injectors can take the form of an analog I/O Interface to generate and inject voltage and current signals into the electronic board under test, according to the values of the test vectors. It can also measure and record analog signals, such as voltages, currents, or waveforms, from various test points within the circuit, for example thanks to a sensor interface, for connecting external sensors or probes to the electronic board under test. These sensors can, in some implementation, also measure, in addition to voltage or current, various parameters, such as temperature, humidity, or electromagnetic radiation. This can for example allows enabling more comprehensive testing under different environmental conditions. In some implementations the ECTD may also comprise a Digital I/O Interface which enables the ECTD to apply digital input vectors (combinations of logic levels) to the electronic board under test, when such digital input vectors are implemented. It can also monitor and record digital output signals from the circuit, facilitating the testing of digital components and logic circuits. In some implementations, the ECTD also comprises a data Acquisition and Signal Conditioning module DASCm for capturing and processing the sensor data, and may take the form of analog-to-digital converters (ADCs), amplifiers, filters, and other signal processing components.

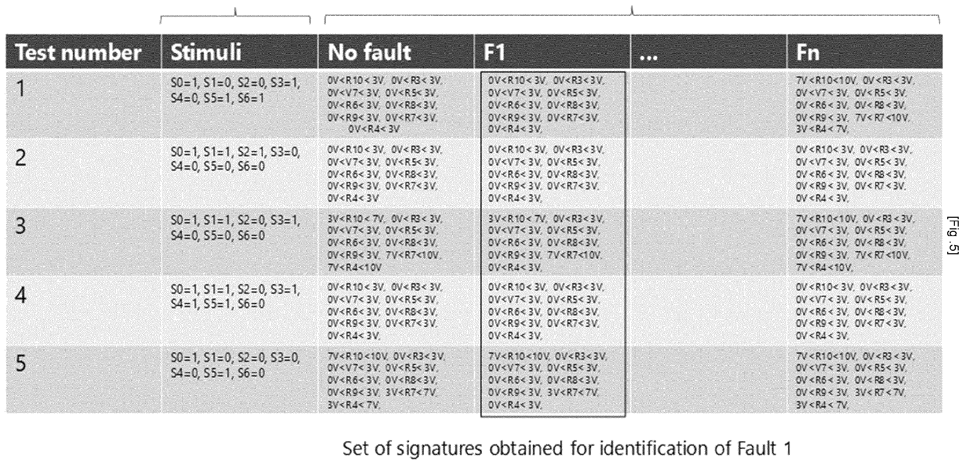

The ECTD also have communication means COM which are used for retrieving (from an authorized location or device) one or several digital testing packages (DTP(s)). The authorized location or device can for example be an USB key, which is connected to the ECTD or a computing environment (e.g. a server or the cloud) to which the ECTD is connected through a communications network. Whatever the situation is, the DTPs comprises at least a test vector database (TVD). The DTP implements, in some embodiments, a cryptographic container which comprises means that allow the DTP to be used on authorized ECTD only and/or for specific purposes and/or predetermined durations. A TVD can take the form of flat csv file or a more complex xml file or other formats. Each line or each element (son of the root element) comprises data of a test vector. The DTP can take the form of a compressed and/or archive file, with some specific attributes, as detailed below. An example of plain comprehensive extract form a TVD is provided in figure 5. This example TVD is built based on previous knowledge of the electronic board and its possible faults, and/or with dedicated technologies. This example TVD is built to attribute the fault location to structural blocs of the electronic board which can be replaced. For instance, in this exemplary TVD, the first vector (1) comprises the application of six stimuli (S1-S6), each of the stimulus having a stimulus value (e.g. 0 or 1 in this example). The stimuli are applied by the ECTD using the injectors Inj. The sensors values are read by the DASCm and or IRSv. On the illustrated example, one gets 9 sensors (R3-R10 and V7) and values are voltages. In this example, faults are determined based on the voltages read at the probes or sensors.

In one embodiment, the ECTD also incorporates several components to manage the cryptographic characteristics of the DTPs (when the DTPs incorporate such characteristics) which contain the TVD. These components ensure secure handling, authentication, and integrity verification of the sensitive testing data. Notably, the ECTD includes a secure storage mechanism, such as an encrypted partition or a dedicated secure element, to store the DTPs and associated cryptographic keys. This storage is for example designed to prevent unauthorized access or tampering with the sensitive data of the DTPs. In addition, the ECTD may incorporate dedicated cryptographic processors or hardware security modules (HSMs) to perform cryptographic operations efficiently. These processors handle decryption, encryption, digital signature verification, and key management. In addition, a key management system is implemented within the ECTD to securely handle and manage the cryptographic keys used for decrypting and authenticating the DTPs. This key management system may include key generation, key storage, key distribution, and key revocation mechanisms. Finally, the ECTD incorporates functionality to verify the digital signatures associated with the DTPs. This verification process ensures the authenticity and integrity of the packages, preventing the use of unauthorized or tampered data (which may cause either a false identification of presumably faulty components or a destruction of the electronic board itself). The interfaces, memory, processing units, sensors, communication means, cryptographic means are communicatively connected thru a bus BS.

The operation mode of the ECTD is for instance, the ECTD is to be plugged on an electronic board so as to determine, with some appropriate test vectors, which are the components or group of components of the electronic board that are either malfunctioning or destroyed.

The ECTD, for each test vector, records the values measured by the various sensors (either included in the ECTD as explained before, on the electronic board itself).

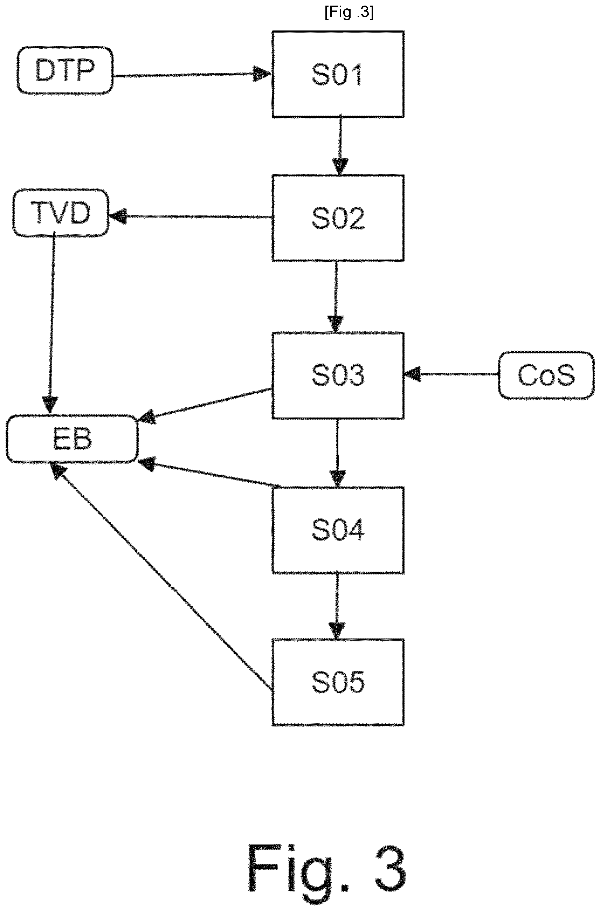

In addition, a method for locating faulty components on an electronic board applying the ECTD and a TVD included in an encrypted DTP is disclosed. The ECTD implements the following method, illustrated in relation with figure 3:
- Obtaining S01 the DTP from the communication interface COM. The package may be obtained from an USB key, plugged into the ECTD, for example. The DTP may also be obtained from a server connected with the ETCD thru a communication network. The DTP is then stored on the storage within the ECTD.
- From the stored DTP, obtaining S02 at least the TVD. Optionally, the DTP may also comprise data representing a connection scheme of the ECTD to the specific electronic board under test, in this case the data representing a connection scheme are also extracted from the DTP and displayed on an appropriate screen (which may be part of the ECTD, as explained above).
- Connecting S03 the ECTD to the electronic board (EB) using appropriate connectors and modules, according to the connection scheme, either the one extracted from the DTP, or the connection scheme provided with the electronic board itself, or by other means.
- Setting S04 the ECTD's power supply unit to provide the required voltage and current levels to the electronic board EB. This operation can be performed automatically by the ECTD itself, as a function of predetermined parameters, for example also included in the DTP (as a test protocol).
- Executing S05 tests according to the test vectors of the TVD and determining the faulty components as a function of the measured sensors signatures of each test.

Hence, determining faulty components on a damaged electronic board is simple, secured and allows preventing false or unreliable results regarding the identified test vectors.

According to the disclosure, the security may be increased thanks to the use of specific security measures and cryptography may be part of the implemented measures. Indeed, as explained above, a key aspect of electronic board testing, is to be sure the tests are properly conducted. Hence, in at least on embodiment, the DTP comprises, in addition to the TVD, a data structure representing a test protocol. The test protocol data structure comprises data that are used by the ECTD to execute the tests according to the test vectors of the TVD. The test protocol data structure comprises:
- data representing a connection scheme, as already explained, notably the connection of the sensors (either in situ sensors, or additional sensors),
- configuration data of the power circuit polarization (including the location(s) of its connection in the electronical circuit),
- test ordering data, defining the order in which the tests should be performed,
- optionally duration data, indicating, for all or part of the test vectors, the duration during which the stimuli (i.e. input vector part specified in each test vector) must be applied before acquiring the result with the sensors,
- optionally electric wave form (current and/or voltage), indicating, for all or part of the test vectors, the form of the stimuli (i.e. input vector part specified in each test vector) that has to be applied,
- logic data to analyse the test results (sensor outputs and their timing) and provide a diagnosis (fault kind and location).

According to the disclosure, once the ECTD obtains the DTP, the obtaining step S02 implements a consistency check step of the DTP. More specifically, the consistency step comprises checking that the DTP comprises both the test protocol data structure and the TVD. In addition, the consistency step also comprises determining that an identifier of the TVD corresponds to an identifier of the expected TVD regarding the electronic board under test. This identifier determining step allows preventing unauthorized forging of DTP by attackers or hackers. In addition, in at least one embodiment, the DTP comprises a piece of data representing an identifier of the electronic board. The consistency check step then comprise a step of checking the piece of data representing the identifier of the electronic board with a corresponding data which may for example be obtained, thanks to a keyboard, by an operator or obtained by scanning a barcode or QR code by the ECTD (when the ECTD comprises such scanning and decoding means) or directly obtained from the electronic board itself (by plugging a digital interface of the ECTD on the electronic board).

In addition, in at least one embodiment, the DTP is cryptographically protected to ensure safe transmission and utilization. To this end, the DTP is cyphered thanks to a cryptographic key. The cryptographic key with which the DTP is cyphered is, as a function of the realisations, for example dedicated to a predetermined ECTD, meaning that only the designated ECTD is able to uncyphered the DTP. This situation can arise, for example when the ECTD is connected to a cloud or a dedicated server, and that the server as forged the DTP specifically for the ECTD. In this situation, a public key architecture may be used by the ECTD and the server for cyphering the DTP. In other situation, the DTP is cyphered with a public key, the counterpart of which (i.e. the private key) is stored by the ECTD in protected memory. Whatever the situation, the key may have a dedicated usable period, ensuring that unproper attempt to use the DTP is unauthorized. Thanks to such measures, the DTP remains protected against attack attempts, by trying to forge fake DTPs for destroying materials during tests and/or misuses of the DTP. Thus, in this situation, the obtaining step S02 first implements a deciphering step, using some cryptographic materials (private/public keys, shared keys, password, etc.), shared or not with a server. The uncyphered DTP is stored in a memory location of the ECTD (secured for example in the security module HSM) and the consistency step is processed. Once the consistency of the DTP is acknowledged, the TVD and optionally the test protocol data structure are extracted. In the event the test protocol data structure exists, the ECTD configures itself according to the data of the test protocol data structure. Otherwise, an operator configures the ECTD. This configuration can occur after steps S02, S03 or S04, depending on the implementations.

Once configured and connected to the electronic board, the ECTD executes the tests of the TVD, as explained below. Once the tests are executed (and that a possible faulty component or group of components are identified) the digital results of the tests (i.e. the measured signatures and/or the faulty components identification) are transmitted to the manufacturer of the electronic board. This transmission can be made either directly by the ECTD, connected to a wireless network for instance, and transmitting the results of the test to a dedicated server or computing architecture. This transmission can also be made by using the USB key that contained the DTP, the results are then stored on the USB key and the transmission of the results is made when the technician is back at his office. The results of the tests that are transmitted and/or recorded for transmission may be encoded so that (only) the manufacturer is able to compare the results with some data for identifying components series that may be subject to default and planning preventive maintenance of other products comprising the same components, thus reducing the unavailability periods for these products.

A context for implementing the ECTD is the following: for example, the customer may return the defective product which is diagnosed at the factory thanks to the device and repaired. The repair may be done by dismantling the supposedly defective board from the product. A maintenance operator may perform the diagnostic with the ECTD and the set of test vectors. After repair, the product is reconditioned and sent back to the client. In another situation, maintenance is performed directly on site. The ECTD is then implemented either by the product manufacturer or by an authorized user, with expected qualifications and credentials, to determine the faulty components of the electronic board and repairing it.

For example, the proposed ECTD and test method is particularly suited for industrial maintenance. It is also suited for maintenance centres which perform maintenance of a diversity of electronic board from various manufacturers. The ECTD is suited for example for maintenance of inventers. For example, an inverter is manufactured by the inverter manufacturer. According to the disclosure, the manufactured inverter includes for example: an interface with an ECTD, logic instructions in the controller (of the inverter) to allow follow test instruction of the ECTD, a modular structure with replaceable blocks, and optionally test points to position the sensors of the ECTD. The inverter is operated by the inverter service user (a client, a company). The type of service provided is e.g. to drive a motor in a pump, fan, conveyor or any other application requiring a variable speed drive. A fault is detected by the inverter service user. Indicators of fault is the generation of a warning signal by the inverter, or the stop of the inverter, or the malfunction of the inverter. The inverter is then provided to the inverter maintainer, or the inverter maintainer moves on-site to perform the maintenance. The ECTD is in possession of the inverter maintainer.

The test vector database TVD, in a given DTP is either dynamically or previously generated by the inverter manufacturer and provided to the inverter maintainer, e.g. by connecting the ECTD to a dedicated device (e.g. USB key, distant server). The method described in relation with figure 3 is implemented and the faulty component(s) is (are) localized by the inverter maintainer. Finally, a replacement block is manufactured by the inverter manufacturer and provided to the inverter maintainer. The repaired inverter is then provided to the inverter service user.

### Testing method

According to the disclosure, the test executing step S05 of an electronic board with the use of the ECTD and of the set of test vectors included in the TVD is explained. The objective is to perform fault identification/localization during a diagnosis in the context of a maintenance to improve maintenance efficiency (accurate and fast localisation of defective component or sub-system...).

During this testing phase, each test vector in set of test vectors is applied to the power electronic board under test. The sensors values are read after each applied stimuli (combination of inputs of the test vector), then encoded as in pre-processing / processing stages (sensors signature encoding) and finally recorded.

The comparison of sensors signatures obtained for the different vectors compared to the expected values for each fault or combination of faults is then used to identify the corresponding fault or combination of faults. The application of the test vectors is preferably performed while the system (including the power electronic board) is "off-line" i.e. not in normal operation, with possibly the requirement to perform some manual operations within the electronic board under test such as, for instance, disconnect its normal power supply input and connect the testing equipment to the electronic board (typically to connect some test sensors to particular signals within the power converter, to connect to control inputs of electronic board and to provide a specific test power supply). The test power supply is for instance a power source which is either current limited or low voltage connected to power converter through a limiting resistor to limit the maximum current to a safe value to avoid degrading healthy components during the tests (for instance some DC bus short circuit can occur during some tests, either due to fault or due to activations of some power switches during test sequences) and commanded from the ECTD thanks to the electronically configurable power supply unit.

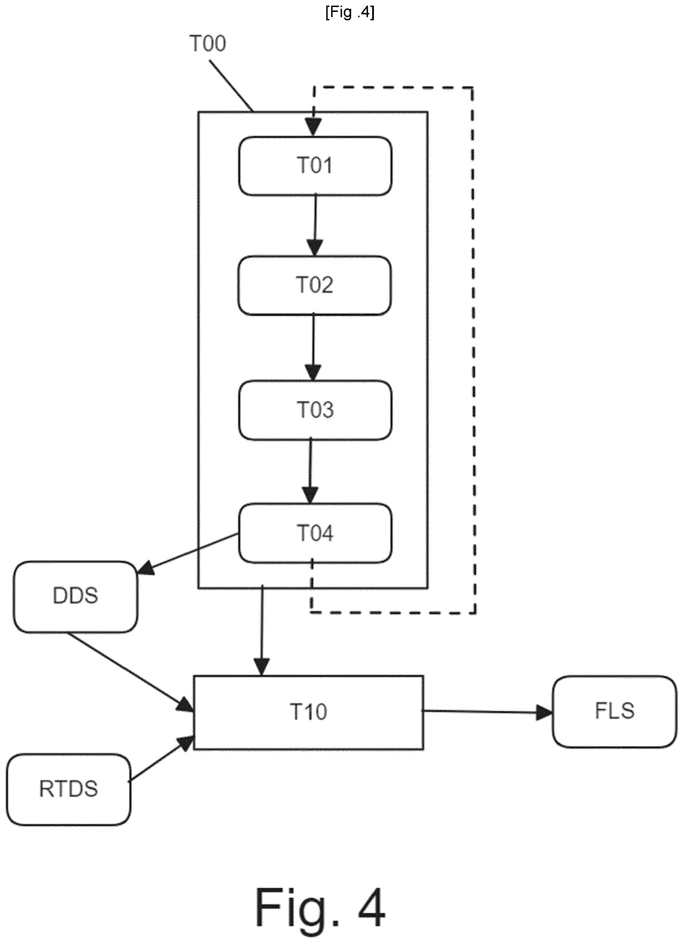

The testing method execution is presented in accordance with figure 4. The testing method optionally comprises a step of placing the device under test (i.e. the actual electronic board) at least partly in connection with the ECTD. According to the disclosure, as previously explained this step can be carried out in several different ways: in situ, i.e. by connecting extensions of the ECTD (cables) to predetermined locations of the electronic board, even though the electronic board remains assembled in the device of which it forms part. This means that the entire device in which the electronic board to be tested is located does not have to be dismantled, and the test results can therefore be obtained more quickly. The maintenance user, in charge of the tests, then connects the ECTD to the electronic board to be tested, according to a predetermined (i.e. supplied) connection diagram, the connection diagram can be part of the DTP (in which the test vectors are stored, as exposed herein before). Another way of carrying out the test is to completely dismantle the electronic board and connect it to the ECTD.

Depending on the implementations, this ECTD can take various forms as previously presented. Whatever the configuration, however, the ECTD is able, for each test vector, to record the values measured by the various sensors. Instructions on how to position the sensors and injectors are also provided for each electronic board to be tested, according to the predetermined (i.e. supplied) connection diagram, for example included in the test protocol data structure.

Once connected to the ECTD, a fault identification method can be implemented. The method can comprise all or part of the following steps:
- at least one iteration of the testing stage T00 steps comprising: applying T01 a test vector of said set of test vectors of the test data structure associated to the electronic board; acquiring T02 values from the sensors associated to the electronic board; optionally encoding T03 the acquired values according to the encoding format used during test vectors generation; storing T04 the optionally encoded acquired values along with the test vector in a diagnosis data structure DDS,
- comparing T10 at least one of said optionally encoded acquired values of the diagnosis data structure DDS with the records RTDS of corresponding signatures of the at least one test vector database TVD, and in the event of a match of at least one of the encoded acquired values, delivering the corresponding fault location FLs.

## Claims

1. A method for locating faulty components on an electronic board (EB), the method being implemented thru by an electronic board test device (ECTD) comprising a processor (Pu) and a memory (Mem), the method comprising:
- obtaining (S01) a digital testing package (DTP), from a communication interface (COM) of the electronic board test device (ECTD),
- from the digital testing package (DTP), the processor (Pu) obtaining (S02) at least one test vector database (TVD),
- connecting (S03) the electronic board test device (ECTD) to the electronic board (EB) using at least one connector of the electronic board test device (ECTD) according to a connection scheme (CoS),
- setting (S04) a power supply unit of the electronic board test device (ECTD) to provide predetermined voltage and/or current levels to the connected electronic board (EB),
- executing (S05) at least one test according to the test vectors of the at least one test vector database (TVD) and determining the faulty components as a function of at least one measured sensor signature of the at least one test.

2. The method according to claim 1, wherein the at least one test vector database (TVD) comprises at least one test vector, each test vector comprising a plurality of input values to be applied to inputs of the electronic board (EB), named input vector, and a plurality of sensor(s) values associated with the input vector, named sensor(s) signatures linked to the number of possible faults on the electronic board (EB).

3. The method according to claim 1, wherein the digital testing package (DTP) comprises, in addition to the test vector database (TVD), the connection scheme (CoS).

4. The method according to claim 1, wherein the processor (Pu) obtaining (S02) the at least one test vector database (TVD) from the digital testing package (DTP) comprises the electronic board test device (ECTD) determining consistency of the digital testing package (DTP), wherein determining consistency comprises checking that the digital testing package (DTP) comprises the at least one test vector database (TVD) and one test protocol data structure.

5. The method according to claim 4, wherein determining consistency of the digital testing package (DTP) further comprises determining that an identifier of the at least one test vector database (TVD) corresponds to an expected identifier regarding the electronic board (EB).

6. The method according to claim 4 or 5, wherein determining consistency of the digital testing package (DTP) further comprises determining that an identifier of the electronic board (EB) corresponds to a prerecorded identifier of the electronic board in the digital testing package (DTP).

7. The method according to any of claim 1 to 6, wherein the processor (Pu) obtaining (S02) the at least one test vector database (TVD) from the digital testing package (DTP) comprises the electronic board test device (ECTD) deciphering the digital testing package (DTP) and storing the uncyphered digital testing package (DTP) in a dedicated memory location of the electronic board test device (ECTD).

8. The method according to claim 7, wherein the electronic board test device (ECTD) deciphering the digital testing package (DTP) comprises the electronic board test device (ECTD) obtaining cryptographic materials dedicated to the digital testing package (DTP).

9. The method according to any of claim 1 to 8, wherein executing (S05) at least one test according to the test vectors of the at least one test vector database (TVD) comprises:
- at least one iteration of a testing stage (T00) steps comprising:
- applying (T01) a test vector of said at least one test vector database (TVD),
- acquiring (T02) values from the sensors associated to the electronic board (EB),
- storing (T04) the acquired values along with the test vector in a diagnosis data structure (DDS),
- comparing (T10) at least one of said acquired values of the diagnosis data structure (DDS) with the records (RTDS) of corresponding signatures of the at least one test vector database (TVD), and in the event of a match of at least one of the acquired values, delivering the corresponding fault location (FLS).

10. The method according to any of claim 1 to 9 wherein it further comprises, after executing (S05) the at least one test, transmitting at least one result of the at least one test to a manufacturer of the electronic board (EB).

11. An electronic board test device (ECTD) for locating faulty components on an electronic board (EB), the electronic board test device (ECTD) comprising a processor (Pu) and a memory (Mem), the electronic board test device (ECTD) further comprising:
- a communication interface (COM) for obtaining a digital testing package (DTP),
- means for the processor (Pu) obtaining at least one test vector database (TVD) from the digital testing package (DTP),
- means for connecting the electronic board test device (ECTD) to the electronic board (EB) using at least one connector of the electronic board test device (ECTD) according to a connection scheme (CoS),
- means for setting a power supply unit of the electronic board test device (ECTD) to provide predetermined voltage and/or current levels to the connected electronic board (EB), and
- means for executing at least one test according to the test vectors of the at least one test vector database (TVD) and determining the faulty components as a function of at least one measured sensor signature of the at least one test.

12. A computer program comprising instructions causing the implementation of the method according to anyone of the claims 1 to 10 when such instructions are run by a processor.

13. A data storage medium comprising digital testing package (DTP) comprising at least one at least one test vector database (TVD) to be obtained by an electronic board test device (ECTD) according to any of claims 1 to 10.
